# EUROPEAN PATENT APPLICATION

(11) **EP 0 908 901 A1**
(43) Date of publication of application: **14.04.1999**
(21) Application number: 98203258.3
(22) Date of filing: 23.09.1998
(51) Int. Cl.: G21K 4/00, G03C 11/02, G03C 5/17, B41M 5/24

(54) **A method for permanently marking X-ray screens**

(30) Priority: 13.10.1997 EP 97203177
(71) Applicant: AGFA-GEVAERT N.V., 2640 Mortsel (BE)
(72) Inventor: Struye, Luc, 2640 Mortsel (BE); Leblans, Paul, 2640 Mortsel (BE)

(57) **Abstract**

A method for permanently marking X-ray screens is provided wherein a radiation curable composition containing a dyestuff is applied to an area of the surface of the screen and wherein the radiation curable composition is irradiated. The radiation curable composition is preferably a UV-curable composition.

## Description

### FIELD OF THE INVENTION

This invention relates to a method for permanently marking objects having a hard polymeric surface. It relates especially to a method for marking X-ray screens, direct emitting screens as well as storage phosphor screens.

### BACKGROUND OF THE INVENTION

In the art of marking objects having a hard polymeric surface it is not self-evident to have a fast, reliable method for producing a mark that is not easily removed by organic solvents, e.g. alcohols, acetone, hexane, etc. or by physical wear.

In the art of making X-ray screens, it is advantageous to provide such a screen with a protective layer on the phosphor layer. This is the case for X-ray screens comprising direct emitting phosphors as well as for X-ray screens comprising photostimulable or storage phosphors. The protective layer protects the phosphor in the phosphor layer from environmental influences, e.g., humidity, vapours etc. and protects the screen against physical damage during use. The protective layer is frequently a hard polymeric layer, making the screen almost insensitive to scratches during use and other forms of physical damage. Such a protective layer can be produced by applying a polymeric composition on top of the phosphor layer and chemically hardening it, as disclosed in **EP-A- 514 146** or in **US-A-4 205 116**. In many cases a radiation cured protective layer, as disclosed in **EP-A-510 754** is applied to the phosphor layer.

In radiographic departments using the screens, it is also common usage to clean such screens with organic solvents to remove dust, fingerprints, etc. The cleaning solution comprises frequently methylethylketone and ethanol as solvent.

On the other hand the producer of the screen wants the screen to be marked so that for each screen the manufacturing history can easily be traced. The radiologist wants that the mark of the screen is printed on the film when a radiograph is made with a light sensitive film in contact with the screen, so as to be able to trace at any moment the film/screen pair used to form the radiological image. Furthermore, it is an advantage that the mark on the screen is easily readable in a dark room, so that when cassettes are manually loaded, it can be checked which screen is present in the cassette at hand. Also official control organisms are demanding a durable marking on X-ray screens. The marking on an X-ray screen is not only required for traceability purposes, but in certain radiographic procedures, e.g., in orthopaedics, the X-ray screens that are used comprise marks, e.g. a grid, that make it possible to measure skeletal distances in the radiographs.

The typical lifetime of an X-ray screen in an hospital is usually not less than five years, thus any marking on the screen must be very durable and must withstand repeated cleaning. The producer of the screen further demands that the marking of the screen can proceed in such a way that the production process has not to be disturbed by the marking of the screens. It is clear, from the above, that the demands on a mark on an X-ray screen are quite severe both in terms of visibility and in terms of durability.

It is therefore still desirable to provide a further method for permanently marking X-rays-screens.

### OBJECTS AND SUMMARY OF THE INVENTION

It is an object of the invention to provide a method for permanently marking X-ray screens.

It is a further object of the invention to provide a method for marking a X-ray screens with a marking that can withstand repeated rubbing with organic solvents.

It is an other object to provide a simple and cost effective method for marking X-ray screens with a marking that can withstand repeated cleaning and that is visible on the diagnostic images made by using the screen.

It is a further object of the invention to provide a method for marking an X-ray screen with a mark that withstands physical stresses during the use of the screen and wherein the marking does not deteriorate the physical strength of the X-ray screen.

Further objects and advantages will become clear from the description hereinafter.

The objects of this invention are realised by providing a method for marking a X-ray screen having a phosphor layer and a protective layer on top of it, forming a first surface of said screen, comprising the steps of :
- applying a radiation curable composition containing a dyestuff on an area of said surface of said screen,
- radiation curing said area of said surface, and
- image-wise removing a portion of said radiation cured area.

The objects of this invention are further realised by providing a method for marking a X-ray screen having a phosphor layer and a protective layer on top of it, forming a first surface of said screen, comprising the steps of :
- image-wise removing said protective layer from an area of said first face of said screen forming an image with pits,
- applying a dyestuff is in said pits,
- further filling said pits with a colourless radiation curable composition and
- radiation curing said radiation curable composition.

### DEFINITIONS

The wording "X-ray" has to be understood as all penetrating radiation and includes i.a. radiation originating from a radioisotope (e.g. a Co60 source), radiation created by an X-ray generator of any type, radiation and high energy particles created by a high energy radiation generator (e.g. Betatron), radiation from a sample labelled with a radioisotope as is the case in e.g. autoradiography.

The wording "X-ray screen" is used to indicate an intensifying screen, i.e. a supported or self-supporting panel comprising a direct emitting phosphor as well as to indicate a storage screen or photostimulable screen, i.e. a supported or self-supporting panel comprising a storage phosphor or a photostimulable phosphor.

The word "phosphor" is used to indicate a direct emitting phosphor as well as to indicate a storage or photostimulable phosphor.

The word "dyestuff" is used to indicate a water or organic solvent soluble dye as well as a pigment.

The word "mark" and the word "image" are in the context of this invention to be understood as a symbol, alphanumeric characters, a picture, a bar code, a combination of the foregoing, etc. In short these words are meant to indicate any permanent means on the X-ray screen that makes it possible to identify a particular screen.

### BRIEF DESCRIPTION OF THE DRAWINGS

Figure 1 shows a schematic view of an X-ray ray marked according to a first and a second implementation of the first method of the invention.
Figure 2 shows a schematic view of an X-ray screen marked according to a third implementation of the first method of the invention.
Figure 3 shows a schematic view of an X-ray screen marked according to a fourth implementation of the first method of the invention.

### DETAILED DESCRIPTION OF THE INVENTION

An X-ray screen can be either self supporting or can comprise a mixture of a phosphor and a binder, coated on a support.

Typical binders are, e.g., gelatine, polysaccharides such as dextran, gum arabic, and synthetic polymers such as polyvinyl butyral, polyvinyl acetate, nitrocellulose, ethylcellulose, vinylidene chloride-vinyl chloride copolymer, polyalkyl (meth)acrylate, vinyl chloride-vinyl acetate copolymer, polyurethane, cellulose acetate, cellulose acetate butyrate, polyvinyl alcohol, polystyrene, polyester, etc. These and other useful binders are disclosed e.g. in **US-A- 2 502 529**, **US-A- 2 887 379, US-A-3 617 285, US-A- 3 300 310, US-A- 3 300 311** and **US-A- 3 743 833**. A mixture of two or more of these binders may be used, e.g., a mixture of polyethyl acrylate and cellulose acetobutyrate. Other useful binders in X-ray screens are hydrogenated styrene-diene block copolymers, having a saturated rubber block, as rubbery and/or elastomeric polymers. The polymer can be represented by the formula A-B-A (tri-block) or by the formula A-B (di-block), wherein A represents styrene and B represents the hydrogenated diene block e.g. ethylene-butylene or ethylene-propylene. Such binders have been disclosed in, e.g., **EP-A- 647 258** and **EP-A- 648 254**. Also binders with Tg ≤ 0 °C and being soluble for at least 5 % wt/wt in ethylacetate can beneficially be used in X-ray screens, as disclosed in **EP-A- 758 012**.

The weight ratio of phosphor to binder is generally within the range of from 50:50 to 99:1, preferably from 80:20 to 99:1, the ratio by volume of phosphor to binding medium is usually more than 70/30 and even more than 85/15. The coating weight of the phosphor particles can be adapted to the desired speed of the radiographic screen or panel, but preferably a coating weight between 5 and 250 mg/cm², most preferably between 20 and 175 mg/cm², is used.

On top of the phosphor layer a protective layer is generally applied. This protective layer is mostly in direct contact with the phosphor layer, bat this is not necessarily so, thin auxiliary layers (conductive layers, layers containing filter dyes, etc. ) can be present between the phosphor layer and the protective layer. Typical protective layers comprise nitrocellulose, ethylcellulose, cellulose acetate or polymethyl(meth)acrylate resin, coated from a solvent. A protective layer on top of the phosphor layer is very often made by coating a radiation (Ultra Violet radiation or electron beam radiation) curable solution on top of the phosphor layer and by curing this solution. The protective layer that is formed in this way not only protects the phosphor containing layer from mechanical and chemical damage but can be given a relief structure for high ease of manipulation, thereby avoiding sticking, friction and electrostatic attraction while keeping of an excellent image resolution. Radiation cured protective layers have been disclosed in , e.**g., EP-A- 510 753** and **EP-A 510 754**.

It has been found that a permanent mark or image on an X-ray screen could easily be produced by a method using a radiation curable composition. Basically the invention can be implemented in two methods, a first method wherein a radiation curable composition a dyestuff is applied on an area of the surface of the screen and the composition is radiation cured and a second method wherein a dyestuff is applied to an area of the surface of the screen, that area is covered with a colourless radiation curable composition and the composition is radiation cured. Although electron beam curable composition can be used, it is preferred to use UV curable compositions for marking X-ray screens in the various methods of the method of the present invention. The general two general methods of the invention, can be implemented in various ways.

### First method

In the first method of the present invention the marking of the screen proceeds by applying radiation curable composition containing a dyestuff to an area of the surface of the screen. The marking of the screen proceeds preferably on the face of the screen whereon the layer containing phosphor particles and the protective layer on top of this layer is present. In a first implementation of the first method of this invention, the radiation curable composition containing a dyestuff is image-wise applied to an area of the surface of the X-screen and that area is overall cured. The radiation curable composition is preferably a UV-curable (Ultra Violet light curable) composition. Typical useful UV-curable compositions with a dyestuff, for use in this invention, are UV-curable inks as described in, e.g., **US-A-4 303 924, US-A-5 237 917, EP-A- 540 203, EP-A-465 039, US-A-4 228 438, EP-A-071 345, WO-A-97 31071, US-A-4 680 368, US-A-4 649 064, Us-A-4 751 102, EP-A-351 328** ,etc.

The image-wise application of such a UV-curable composition to the surface of the screen proceeds preferably by ink-jet printers with UV-curable dyed inks, , although any means for image-wise applying a UV curable composition on a surface (e.g. hand-writing, electrostatographic means with liquid toner, etc.), can be used in the first method of the invention to apply the UV-curable composition.

A very comprehensive overview of radiation curable compositions and the commercial availability of compounds for said compositions can be found in the series "Chemistry and Technology of UV and EB formulation for coatings, inks and paints" edited by P.K.T. Oldring, published by SITA Technology, London SW18 4JQ, England 1991 (five volumes).

Optionally additives and pigments or dyes can be incorporated in the composition. The UV-curable inks used in a method according to this invention can further comprise water and/or organic solvents.

Typical UV-curable inks for ink-jet printing have been disclosed in, among others, the already cited **US-A-4 303 924, Us-A-5 237 917, EP-A- 540 203, EP-A-465 039, US-A-4 228 438, EP-A-071 345,** and further in **EP-A-407 054, EP-A-533 168, EP-A-659 039, US-A-5 270 368** , **US-A-5 641 346** and **US-A-5 623 001**.

Useful UV-curable ink-jet inks for the method of this invention are commercially available from, e.g., Wiedenbach, Moos, Germany; Domino Printing Ltd, UK; Naxdar Inc, North Branch street, Chicago, IL, USA and Coates Electrographics Ltd, Bath, United Kingdom.

The UV-curing can proceed by any UV lamp or UV-laser known in the art. Very suitable lamps are e.g. high pressure mercury lamps with giving light with an intensity between 20 W/cm and 150 W/cm. Also Medium pressure mercury lamps, microwave mercury lamps, Iron-iodide-doped mercury lamps, xenon lamps and XeCl excimer lamps can be used for radiation curing in the method according to this invention. Also excimer lasers, e.g., the lasers sold by ATL Lasertechniques, Camden, NJ, USA, are useful in this invention.

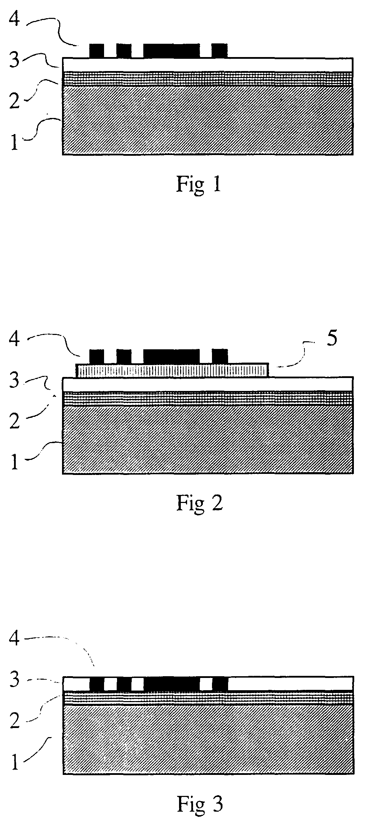

Figure 1 shows schematically an X-ray screen marked according to this method of the invention. The screen comprises a support (1), a phosphor layer (2) a protective layer (3) and an top of an area of said protective layer an image-wise applied layer of a UV-cured composition (4).

In a second implementation of the first method of the invention, the UV-curable composition containing a dyestuff, having a hue different from the colour of the surface of the screen, is non-image-wise applied to an area of the surface of the X-ray screen and then cured. Thus on top of the protective layer of the screen, a layer with a colour different from the overall colour of the screen is formed, having a thickness of some µm It is preferred that the UV curable composition contains a dye or a mixture of dyes providing a black appearance of the layer on top of the protective layer of the X-ray screen The UV curable composition can be brought on an area of the surface of the X-ray screen by any means known in the art for non-image-wise application of inks or paints. The curable composition can be applied by brushing, spraying, etc. It can also be applied by a wick with one end hanging in a reservoir of curable composition and the other end touching the surface of the screen, then the curable composition is applied when the screen passes the wick.

The same UV-curable compositions as those used in the first implementation of the first method of the invention can be used in this second implementation and the curing can proceed with the same kind of UV-lamps or UV lasers. After the curing, in the area of the surface of the screen covered with the UV-cured dyed composition a portion of this composition is image-wise removed. The removal of said portion can be mechanical, e.g., a stamp with an image, cuts a portion of the area away, it can be chemical, e.g., by image-wise applying a compound capable of changing the colour of the dyestuff in the cured composition or it can proceed by image-wise exposing the area covered with the curable composition to laser light having enough energy to image-wise ablate the UV-cured composition on the area of the screen, thus forming an image. It is preferred, in this second implementation of the first method of the invention, to use laser ablation to form the image. The energy of the laser radiation is adapted so that only the layer on top of the protective layer of the screen is ablated so that the protective layer of the screen remain unimpaired. Typical suitable lasers for use in this implementation of the first method of the invention are Nd:YAG lasers, Nd:YLF lasers or CO₂ lasers. Preferably the lasers have a power around 10 W and can be used in continuous or pulsed mode. Such lasers are commercially available from, e.g., Spectra Diode Labs, San Jose, CA, USA. The result of this second implementation of the first method according to this invention is finally equal to the result of the first implementation as shown in figure 1.

In a third implementation of the first method of the invention first an area of the surface of the X-ray screen is covered with a first radiation curable composition containing a dyestuff having a first hue. This area is then radiation cured, forming a first radiation cured layer on said area. On top of this first radiation cured layer a second radiation curable composition containing a dyestuff having a second hue, that contrasts with said first hue, is applied and also radiation cured forming a second cured layer on said area. Then said second cured layer is image-wise removed and the first cured layer is left unimpaired, in his way a visible image is formed on the surface of the X-ray screen.

The UV curable composition can be brought on an area of the surface of the X-ray screen by any means known in the art for non-image-wise application of inks or paints. The curable composition can be applied by brushing, spraying, etc. It can be applied by a wick with one end hanging in a reservoir of curable composition and the other end touching the surface of the screen , then the curable composition is applied when the screen passes the wick.

The same UV-curable compositions as those used in the first and second implementation of the invention can be used in this second implementation and the curing can proceed with the same kind of UV-lamps. After the curing of the second radiation curable composition, a portion of this composition is image-wise removed. The removal of said portion can be mechanical, e.g., a stamp with an image, cuts a portion of the area away, it can be chemical, e.g., by image-wise applying a compound capable of changing the colour of the dyestuff in the cured composition or it can proceed by image-wise exposing the area covered with the curable composition to laser light having enough energy to image-wise ablate the UV-cured composition on the area of the screen, thus forming an image. It is preferred, in this third implementation of the invention, to use laser ablation to form the image. The energy of the laser radiation is adapted so that only the layer on top of the protective layer of the screen is ablated so that the protective layer of the screen remain unimpaired. Typical suitable lasers for use in this implementation of the first method of the invention are Nd:YAG lasers, Nd:YLF lasers or CO₂ lasers. Preferably the lasers have a power around 10 W and can be used in continuous or pulsed mode. Such lasers are commercially available from, e.g., Spectra Diode Labs, San Jose, CA, USA.

Figure 2 shows schematically an X-ray screen marked according to this implementation of the first method of the invention. The screen comprises a support (1), a phosphor layer (2) a protective layer (3) and an top of an area of said protective layer a layer (5) of a UV-cured composition with a first hue and on top of this layer (5) a layer of a UV-cured composition with a second hue (4) that image-wise has been removed. The protective layer 3 nor the UV-cured layer (5) are damaged by the ablation.

It is preferred in this third implementation of the first method of the invention, that the first radiation curable composition comprises a dyestuff giving a dark hue, preferably black and the second first radiation curable composition comprises a dyestuff giving a light hue, e.g. yellow, light green, etc.

It is also possible, in this implementation of the first method of the invention, to cover an area of the screen with a solution of a non-radiation curable dyestuff having a first hue, then on top of this first layer of dyestuff, a radiation curable composition containing a dyestuff having a second hue, that contrasts with said first hue, is applied and radiation cured, forming a cured layer on said area. Then said cured layer is image-wise removed and the first layer of dyestuff is left unimpaired, in this way a visible image is formed on the surface of the X-ray screen. After the application of the first layer of dyestuff on the area of the screen to be marked, this area of the screen is preferably heated, thus fixing the first dyestuff to the screen, before the radiation curable composition with the second dyestuff is applied.

In the fourth implementation of the first method of this invention, the protective layer and, if so desired, part of the phosphor layer of the X-ray screen is image-wise removed over an area of the surface of the screen. Thus an image with pits in an area of the screen is formed. The pits are then filled with a radiation curable composition with a dyestuff and the this composition is cured. So a mark is formed on the screen while the surface of the screen remains level, while in the three foregoing implementations the mark formed a relief on the surface of the screen. In figure 3, a screen being marked with the fourth implementation of the first method of this invention is shown. On a support 1, a phosphor layer (2) is present and on top of it a protective layer (3) the protective layer has been removed on some areas and the pits are filled with a radiation curable composition (4), having a dyestuff with a colour different from the colour of the screen. The fourth implementation is a very preferred implementation of the first method of the invention, for several reasons :
- The screen is level on all the surface, so during use when, e.g., an edge of a film contacting the screen scrapes over the mark, the risk of abrasion of the mark is almost non-existent.
- The protective layer of the screen has be damaged by the image-wise ablation, but since the pits are filled with a UV-curable composition comprising reactants and solvents equal to those use to form the protective layer, the protective layer is after curing of the mark totally restored in its integrity.

### The second method

In the second method of this invention, a dyestuff is applied to an area of the surface of the screen, that area is covered with a colourless radiation curable composition and this composition is radiation cured.

Also this method can be realised in various ways. In a first implementation of the second method de mark on the screen is produced by image-wise applying a dyestuff, with a hue different from the hue of the surface of screen and absorbing the light emitted by the screen, to an area of the screen by any known means. The image-wise application can proceed by handwriting, printing, etc.. Preferably the image-wise application proceeds by ink-jet-printing. After printing, the area of the screen carrying the mark is non-image-wise covered with a colourless UV-curable composition or the whole surface of the screen is non-image-wise covered with a colourless UV-curable composition that afterwards is cured. In this case the mark is protected from environmental influences and, when the whole surface of the screen is covered, the surface of the screen is level with the advantages mentioned above.

The application of the dyestuff can proceed by ink-jet printing systems as known for the printing on objects in a factory environment wherein the objects pass the printing station in an almost continuous flow.

The dyestuff can, in the first implementation of the second embodiment of the invention, also be applied by contacting an area of the surface of the screen to an hot-stamping-foil and then hot-stamping the desired information on the screen in accordance with image data. It may be beneficial, in this implementation of the method according to this invention, to treat the area of the surface of the screen that is to be contacted by the hot-stamping-foil first with a corona discharge, producing a very stable mark on the screen.

The further application of the UV-curable composition can proceed by simple ways, since this application is a non-image-wise application. The application of the UV-curable composition can proceed, as explained above, by any means known in the art for non-image-wise application of inks or paints. The curable composition can be applied by brushing, spraying, etc. It can be applied by a wick with one end hanging in a reservoir of curable composition and the other end touching the surface of the screen , then the curable composition is applied when the screen passes the wick.

It is possible to print the mark on the screen directly on the phosphor layer, before the protective layer is applied. Thus, in the production of the screen the workflow has not to be changed much for applying a mark on the screen by the first implementation of the second method of this invention.

Very useful UV-curable colourless compositions for covering the mark on the screen in this first implementation of the second method of this present invention contain as primary components :
(1) a cross-linkable prepolymer or oligomer,
(2) a reactive diluent monomer,
(3) a photoinitiator.

A second implementation, of the second method of this invention, resembles greatly the fourth implementation of the first method of this invention. Also in this implementation, the protective layer and, if so desired, part of the phosphor layer of the X-ray screen are image-wise removed over an area of the surface of the screen. Thus an image with pits in an area of the screen is formed. The pits are then filled not with a radiation curable composition containing a dyestuff but a dyestuff is applied on the bottom of the pits and then the pits are further filled with a colourless UV-curable composition, whereafter this composition is cured. So a mark is formed on the screen while the surface of the screen remains level. This implementation of the second method of the invention is a very preferred implementation, for the same reasons as set out above when describing the fourth implementation of the first method according to this invention.

## Claims

1. A method for marking a X-ray screen having a phosphor layer and a protective layer on top of it, forming a first surface of said screen, comprising the steps of :
- applying a radiation curable composition containing a dyestuff on an area of said surface of said screen,
- radiation curing said area of said surface, and
- image-wise removing a portion of said radiation cured area.

2. A method for marking a X-ray screen according to claim 1, wherein
a first radiation curable composition containing a dyestuff with a first hue is applied on said area of surface of said screen,
a second radiation curable composition containing a dyestuff with a first hue is applied on top of said first composition,
both layers are radiation cured, thus forming a first and a second cured layer on said area, and
said second layer is image-wise removed, forming an image having said first hue on a background having said second hue.

3. A method according to claim 1, wherein
- said protective layer is image-wise removed from an area of said first face of said screen forming an image with pits,
- said pits are filled with a radiation curable composition containing a dyestuff and
- said radiation curable composition in said pits is radiation cured.

4. A method according to any of the preceding claims, wherein said radiation curable composition is UV-curable.

5. A method for marking a X-ray screen having a phosphor layer and a protective layer on top of it, forming a first surface of said screen, comprising the steps of :
- image-wise removing said protective layer from an area of said first face of said screen forming an image with pits,
- applying a dyestuff is in said pits,
- further filling said pits with a colourless radiation curable composition and
- radiation curing said radiation curable composition.

6. A method according to claim 5, wherein said radiation curable composition is UV-curable.
